# EUROPÄISCHE PATENTSCHRIFT

(11) **EP 2 126 990 B1**
(45) Veröffentlichungstag und Bekanntmachung des Hinweises auf die Patenterteilung: **25.09.2013**
(21) Anmeldenummer: 08707045.4
(22) Anmeldetag: 15.01.2008
(51) Int. Cl.: H01L 35/00

(54) **FAHRZEUG MIT EINEM THERMOELEKTRISCHEN GENERATOR**
VEHICLE HAVING A THERMOELECTRIC GENERATOR
VÉHICULE COMPRENANT UN ALTERNATEUR THERMOÉLECTRIQUE

(30) Priorität: 03.02.2007 DE 102007005520
(43) Veröffentlichungstag der Anmeldung: 02.12.2009
(73) Patentinhaber: Bayerische Motoren Werke Aktiengesellschaft, 80809 München (DE)
(72) Erfinder: RICHTER, Rainer, 81247 München (DE); EDER, Andreas, 80939 München (DE)
(86) Internationale Anmeldenummer: PCT/EP2008/000243
(87) Internationale Veröffentlichungsnummer: WO 2008/095582

(56) Entgegenhaltungen:
- DE-A1-102005 005 077
- GB-A- 2 381 377
- JP-A- 63 111 268
- US-A- 3 817 043
- US-A- 4 095 998

## Beschreibung

Die vorliegende Erfindung betrifft ein Fahrzeug mit einem thermoelektrischen Generator gemäß dem Oberbegriff des Patentanspruches 1.

Ein derartiges Fahrzeug ist aus der DE 10 2005 005 077 A1 bekannt. Zum relevanten Stand der Technik zählen ferner die GB 2 318 377 A, US 3 817 043, US 4 095 998 sowie die JP 63-111268 A.

Unter dem Begriff "thermoelektrischer Generator" wird in der vorliegenden Patentanmeldung eine Vorrichtung verstanden, die mit einer Wärmequelle und einer Wärmesenke in thermischer Verbindung steht und die aus der Temperaturdifferenz unter Nutzung des aus der Physik bekannten "Seebeck-Effekts" eine elektrische Spannung bzw. einen elektrischen Strom erzeugt. Bei einem thermoelektrischen Generator handelt es sich also im Prinzip um eine physikalisch umgekehrt arbeitende Peltier-Anordnung.

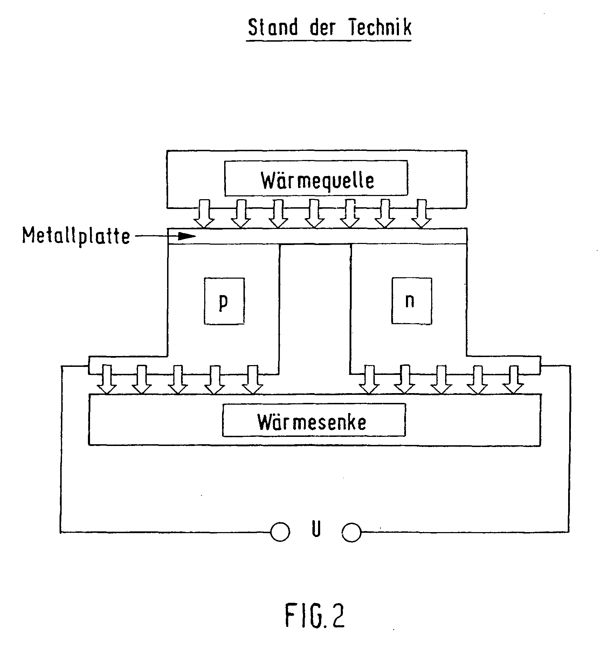

Ein thermoelektrischer Generator weist zwei unterschiedliche Halbleitermaterialen auf, die, ähnlich wie in der Prinzip-Darstellung der Figur 2 gezeigt ist, thermisch und elektrisch leiten miteinander verbunden sind. Setzt man diese Materialpaarung einer Temperaturdifferenz zwischen einer Wärmequelle und einer Wärmesenke aus, bildet sich zwischen den beiden Materialschenkeln eine elektrische Spannung (Thermospannung). Durch Kombination einer Vielzahl solcher Elemente können mit einer entsprechend leistungsfähigen Wärmequelle wirtschaftlich nutzbare elektrische Leistungen erzielt werden.

Bei modernen Straßenfahrzeugen mit Verbrennungsmotor werden gegenwärtig etwa 2/3 der im Kraftstoff enthaltenen Energie in Form von Wärme an die Umgebung abgegeben. Es gibt bereits eine Vielzahl von Ansätzen, die sich mit der Nutzung dieser "Abwärme" befassen. In der älteren, nicht vorveröffentlichten Patentanmeldung DE 10 2006 057 662.4 ist ein Fahrzeug mit einem thermoelektrischen Generator beschrieben, der im Abgasstrang angeordnet ist und einen Teil der im Abgas enthaltenen Wärme in elektrische Energie umwandeln soll. Mit der Nutzbarmachung der im Abgas enthaltenen Energie befassen sich eine Vielzahl weiterer Patentanmeldungen, z.B. die US 4 673 863 A, DE 42 08 358 A1, DE 41 18 979 A1, JP 07012009 A, US 5 625 245, US 6 028 263 A, US 5 974 803, US 20030223919 A1, DE 100 41 955 A1, WO 2004/059138 A1 sowie WO 2005/020422 A1.

Darüber hinaus ist aus der DE 10 2005 058 202 A1 eine Anordnung bekannt, bei der mittels eines thermoelektrischen Generators Abwärme eines Motors in elektrische Energie umgewandelt wird, wobei der thermoelektrische Generator an den Kühlwasserkreis des Motors angeschlossen ist.

Aufgabe der Erfindung ist es, auch bei abgestelltem Fahrzeug die in einzelnen Fahrzeugkomponenten gespeicherte Restwärme mittels eines in einfacher Weise und kompakt angeordneten thermoelektrischen Generators in elektrische Energie umzuwandeln.

Diese Aufgabe wird durch die Merkmale des Patentanspruches 1 gelöst. Vorteilhafte Ausgestaltungen und Weiterbildungen der Erfindung sind den Unteransprüchen zu entnehmen.

Ausgangspunkt der Erfindung ist ein Fahrzeug mit einer "Wärme abgebenden Komponente" und einem thermoelektrischen Generator. Bei der Wärme abgebenden Komponente kann es sich beispielsweise um den Fahrzeugmotor (Verbrennungsmotor) bzw. um dessen Motorblock bzw. Motorgehäuse handeln, um die Ölwanne des Fahrzeugmotors oder um eine andere Komponente des Motors, die einen guten Wärmeübergang ermöglicht. Alternativ dazu kann es sich bei der Wärme abgebenden Komponente auch um ein Getriebe, wie z. B. ein Automatikgetriebe, Handschaltgetriebe, automatisiertes Getriebe, Verteilergetriebe, Achsgetriebe, o. ä. handeln. Der thermoelektrische Generator weist ein mit der "Wärme abgebenden Komponente" thermisch gekoppeltes "Wärme aufnehmendes Element" auf. Aus dem Temperaturgefälle zwischen dem Wärme aufnehmenden Element und einer Wärmesenke erzeugt der thermoelektrische Generator elektrische Energie. Die Wärmesenke kann z. B. durch die Umgebungslufi (Fahrtwind) oder durch ein Kühlmittel eines Kühlkreislaufs gebildet sein, an den das Wärme aufnehmende Element angeschlossen ist.

Der Kern der Erfindung besteht darin, dass der thermoelektrische Generator mit seinem Wärme aufnehmenden Element unmittelbar an der Wärme abgebenden Komponente angeordnet und thermisch leitend damit verbunden ist. Dadurch wird in einfacher Weise ein guter Wärmeübergang zwischen der Wärme abgebenden Komponente und dem Wärme aufnehmenden Element des thermoelektrischen Generators erreicht. Vorzugsweise sind die aneinander anliegenden Flächen der Wärme abgebenden Komponente und des Wärme aufnehmenden Elements jeweils aus einem Material hergestellt, das eine hohe Wärmeleitfähigkeit aufweist. Das Wärme aufnehmende Element des thermoelektrischen Generators könnte z.B. aus Kupfer hergestellt sein.

Die von dem thermoelektrischen Generator erzeugte elektrische Energie kann zum Laden eines im Fahrzeug vorgesehenen elektrischen Energiespeichers, z. B. einer Batterie bzw. eines Kondensators aber auch unmittelbar zur Stromversorgung diverser im Fahrzeug vorgesehener elektrischer Verbraucher, wie z. B. der Hifi-Anlage, Klimaanlage, Gebläse etc. verwendet werden.

Nach einer Weiterbildung der Erfindung ist vorgesehen, dass die von dem thermoelektrischen Generator erzeugte elektrische Energie dazu genutzt wird, einen im Fahrzeug vorgesehenen elektrischen Energiespeicher, z. B. eine Batterie oder einen Kondensator nach dem Abschalten des Verbrennungsmotors warm zu halten. Beispielsweise kann eine elektrische Heizeinrichtung vorgesehen sein, die nach dem Abschalten des Fahrzeugs von dem thermoelektrischen Generator mit elektrischer Energie versorgt wird und z. B. die Batterie zumindest für eine gewisse Zeitdauer heizt bzw. warm hält.

Alternativ oder ergänzend dazu kann die nach dem Abschalten des Verbrennungsmotors mittels des thermoelektrischen Generators erzeugte elektrische Energie auch dazu verwendet werden, bestimmte Komponenten, deren Betriebstemperatur beim erneuten Starten des Verbrennungsmotors verbrauchsrelevant ist, warm zu halten. So kann mit der nach dem Abschalten des Verbrennungsmotors vom thermoelektrischen Generator erzeugten elektrischen Energie beispielsweise das Motoröl, das Kühlwasser beheizt werden oder verbrauchsrelevante Komponenten wie die Kurbelwelle, der Ventiltrieb, die Kolben etc. beheizt bzw. warm gehalten werden.

Zusammenfassend werden mit der Erfindung folgende Vorteile erreicht:
- Ein Teil der Wärme, die im Fahrbetrieb über die Motoroberfläche an die Umgebungsluft abgegeben wird, kann in elektrische Energie umgewandet werden. Dadurch wird der Generator entlastet und Kraftstoff eingespart, was die Energiebilanz des Fahrzeugs verbessert.
- Nach Abstellen des Fahrzeugs kühlt der Motor über einen Zeitraum von mehreren Stunden ab. Die im Motorblock gespeicherte Wärme wird über Strahlung und Konvektion an die Umgebungsluft abgegeben. Mittels des thermoelektrischen Generators kann auch bei stehendem Fahrzeug ein Teil der im Motor gespeicherten Wärme in elektrische Energie umgewandet werden.
- Im Vergleich zu herkömmlichen Ansätzen, bei denen der thermoelektrische Generator in den Abgasstrang integriert ist, besteht bei einer Anbringung des thermoelektrischen Generators am Motorblock, am Getriebegehäuse oder am Achsgetriebegehäuse ein deutlich geringeres technisches Risiko.
- Im Vergleich zu einem in den Abgasstrang integrierten thermoelektrischen Generators entstehen bei einer Anordnung unmittelbar am Motor aufgrund der geringen Temperaturschwankungen der Heißseite geringe Spannungsschwankungen, was den technischen Aufwand zur Glättung der elektrischen Spannung verringert.

Im Folgenden wird die Erfindung im Zusammenhang mit der Zeichnung näher erläutert.
- Figur 1: zeigt das Grundprinzip der Erfindung in schematischer Darstellung; und
- Figur 2: zeigt das Grundprinzip eines thermoelektrischen Generators.

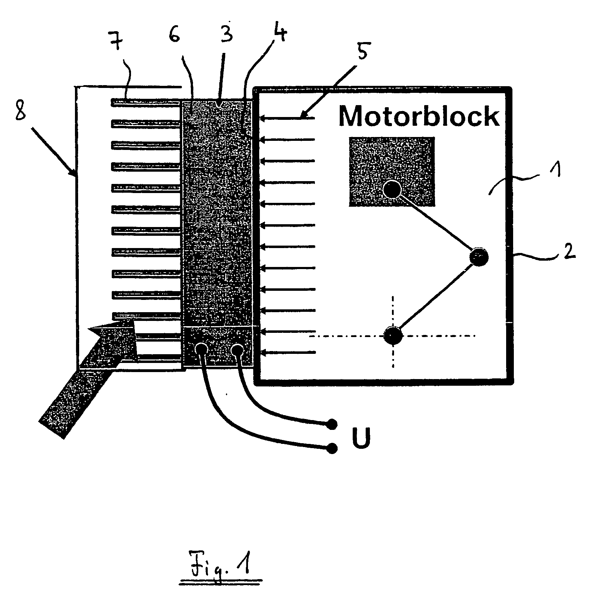

Figur 1 zeigt einen Verbrennungsmotor 1 mit einem Motorblock bzw. einem Motorgehäuse 2, an dessen Außenseite ein thermoelektrischer Generator 3 angeordnet ist. Die "Wärme aufnehmende Seite" 4 des thermoelektrischen Generators 3 liegt flächig am Motorgehäuse 2 an, wodurch ein guter Wärmeübergang zwischen dem Motorgehäuse 2 und der Wärme aufnehmenden Seite 4 des thermoelektrischen Generators 3 erreicht wird. Der Wärmestrom vom Motor 1 zum thermoelektrischen Generator 3 ist durch Pfeile 5 symbolisiert.

Die Wärme abgebende Seite 6 des thermoelektrischen Generators 3 ist mit Kühlrippen 7 versehen. Die Wärme abgebende Seite 6 und die Kühlrippen 7 sind mittels eines Abschirmblechs 8 vor Wärmestrahlung des Verbrennungsmotors abgeschirmt. Die Kühlrippen 7 werden während der Fahrt von Fahrtwind umströmt. Dadurch wird ein guter Wärmeübergang von dem thermoelektrischen Generator an die Umgebungsluft bzw. an den Fahrtwind erreicht. Aus der an dem thermoelektrischen Generator 3 anliegenden Temperaturdifferenz ergibt sich in bekannter Weise eine elektrische Spannung U, die als Ladespannung für das elektrische Bordnetz des Fahrzeugs verwendet werden kann.

Zur Optimierung des Wärmeübergangs von dem thermoelektrischen Generator 3 an die Umgebungsluft kann diese durch ein Luftleitelement (nicht dargestellt) gezielt in Richtung der Kühlrippen 7 kanalisiert werden. Es ist auch denkbar, zusätzlich ein elektrisches Gebläse vorzusehen, mit dem die Kühlrippen 7 zusätzlich "belüftet" werden.

Selbstverständlich ist anstelle einer Luftkühlung des thermoelektrischen Generators 3 auch eine Wasserkühlung denkbar. Die Wärme abgebende Seite 6 des thermoelektrischen Generators bzw. die damit verbundenen Kühlrippen können z.B. an einen Kühlkreislauf des Fahrzeugs angeschlossen werden, wobei eine Kühlmittelpumpe vorgesehen sein kann, welche Kühlmittel zu den Kühlrippen 7 pumpt und die Wärmeabfuhr somit weiter verbessert.

## Patentansprüche

1. Fahrzeug mit einer Wärme abgebenden Komponente (1) und einem thermoelektrischen Generator (3), der ein mit der Wärme abgebenden Komponente (1) thermisch gekoppeltes, Wärme aufnehmendes Element (4) aufweist, und der aus dem Temperaturgefälle zwischen dem Wärme aufnehmenden Element (4) und einer Wärmesenke elektrische Energie erzeugt, wobei der thermoelektrische Generator (3)
• unmittelbar an der Wärme abgebenden Komponente (1) angeordnet und thermisch leitend damit verbunden ist,
• ein mit Kühlrippen (7) versehenes Wärme abgebendes Element (6) aufweist und
• ein Wärme abgebendes Element (6) aufweist, welches mittels eines Abschirmelements (8) gegenüber der von der Wärme abgebende Komponente (1) abgegebenen Wärmestrahlung abgeschirmt ist,
**dadurch gekennzeichnet, dass**
die Wärme abgebende Komponente (1) ein Motorblock eines Fahrzeugmotors ist und
eine elektrisch betriebene Heiz- bzw. Warmhalteeinrichtung vorgesehen ist, die von dem thermoelektrischen Generator (3) mit elektrischer Energie versorgt wird und die nach dem Abschalten des Fahrzeugmotors (1) einen elektrischen Energiespeicher des Fahrzeugs geheizt bzw. warm hält.

2. Fahrzeug nach Anspruch 1, **dadurch gekennzeichnet, dass** der thermoelektrische Generator unmittelbar an einem Gehäuse (2) des Fahrzeugmotors (1) angeordnet ist.

3. Fahrzeug nach Anspruch 1 oder 2, **dadurch gekennzeichnet, dass** der Fahrzeugmotor (1) ein Verbrennungsmotor ist.

4. Fahrzeug nach einem der Ansprüche 1, bis 3, **dadurch gekennzeichnet, dass** der thermoelektrischen Generator unmittelbar an einer Ölwanne des Fahrzeugmotors (1) angeordnet ist.

5. Fahrzeug nach einem der Ansprüche 1 bis 4, **dadurch gekennzeichnet, dass** das Wärme abgebende Element (6, 7) derart angeordnet ist, dass es von Fahrtwind um- oder durchströmt wird.

6. Fahrzeug nach einem der Ansprüche 1 bis 5, **dadurch gekennzeichnet, dass** ein Gebläse vorgesehen ist, das Kühlluft zu dem Wärme abgebenden Element (6, 7) bläst.

7. Fahrzeug nach einem der Ansprüche 1 bis 6, **dadurch gekennzeichnet, dass** das Wärme abgebende Element (6, 7) an einen flüssigkeitsdurchströmten Kühlkreislauf des Fahrzeugs angeschlossen ist.

8. Fahrzeug nach einem der vorangehenden Ansprüche, **dadurch gekennzeichnet, dass** der thermoelektrische Generator (3) elektrisch mit einem im Fahrzeug vorgesehenen elektrischen Energiespeicher verbunden ist und die von dem thermoelektrischen Generator (3) erzeugte elektrische Energie zum Laden des Energiespeichers eingesetzt wird.

9. Fahrzeug nach einem der vorangehenden Ansprüche, **dadurch gekennzeichnet, dass** der thermoelektrischen Generator (3) unmittelbar mit einem elektrischen Bordnetz des Fahrzeugs verbunden ist und einzelne elektrische Verbraucher des Fahrzeugs mit Strom versorgt.

10. Fahrzeug nach einem der vorangehenden Ansprüche, **dadurch gekennzeichnet, dass** eine elektrisch betriebene und von dem thermoelektrischen Generator (3) mit elektrischer Energie versorgte Heiz- bzw. Warmhalteeinrichtung vorgesehen ist, die bei abgeschaltetem Fahrzeugmotor (1) Betriebsflüssigkeiten, wie das motoröl oder das Kühlwasser, oder einzelne Komponenten bzw. Baugruppen des Fahrzeugmotors (1), wie die Kurbelwelle, den Ventiltrieb oder Kolben, elektrisch beheizt bzw. warm hält.

## Claims

1. A vehicle comprising a heat-emitting component (1) and a thermoelectric generator (3) comprising a heat-absorbing element (4) thermally coupled to the heat-emitting component (1) and generating electric energy from the temperature gradient between the heat-absorbing element (4) and a heat sink, wherein the thermoelectric generator (3)
• is disposed immediately at the heat-emitting component (1) and is thermally conductively connected thereto,
• comprises a heat-emitting element (6) with cooling fins (7) and
• comprises a heat-emitting element (6) screened by an element (8) against the heat radiated by the heat-emitting component (1),
**characterised in that**
the heat-emitting component (1) is a vehicle engine block and
an electrically operated heating or heat-retaining device is provided and supplied by the thermoelectric generator (3) with electric energy and heats or maintains the heat of an electric energy storage on the vehicle after the engine (1) has been switched off.

2. A vehicle according to claim 1, **characterised in that** the thermoelectric generator is disposed directly at a casing (2) of the vehicle engine (1).

3. A vehicle according to claim 1 or claim 2, **characterised in that** the engine (1) is an internal combustion engine.

4. A vehicle according to any of claims 1 to 3, **characterised in that** the thermoelectric generator is disposed immediately at an oil sump of the vehicle engine (1).

5. A vehicle according to any of claims 1 to 4, **characterised in that** the heat-emitting element (6, 7) is disposed so that the head wind flows around or through it.

6. A vehicle according to any of claims 1 to 5, **characterised in that** a fan is provided and blows cooling air towards the heat-emitting element (6, 7).

7. A vehicle according to any of claims 1 to 6, **characterised in that** the heat-emitting element (6, 7) is connected to a vehicle cooling circuit through which a fluid flows.

8. A vehicle according to any of the preceding claims, **characterised in that** the thermoelectric generator (3) is electrically connected to an electric energy storage provided in the vehicle and the electric energy generated by the thermoelectric generator (3) is used to charge the energy storage.

9. A vehicle according to any of the preceding claims, **characterised in that** the thermoelectric generator (3) is directly connected to an electric vehicle supply system and supplies electricity to individual loads on the vehicle.

10. A vehicle according to any of the preceding claims, **characterised in that** an electrically operated heating or heat-retaining device supplied with electric energy by the thermoelectric generator (3) is provided and, when the engine (1) is switched off, electrically heats or maintains the temperature of operating liquids such as the engine oil or the cooling water, or individual components or sub-assemblies of the engine (1), such as the crankshaft, the valve drive or pistons.

## Revendications

1. Véhicule équipé d'un composant (1) dégageant de la chaleur et d'un générateur thermoélectrique (3) couplé thermiquement au composant (1) dégageant de la chaleur, un élément (4) récepteur de chaleur qui génère de l'énergie électrique à partir de la différence de température entre l'élément (4) récepteur de chaleur et un puits à chaleur,
le générateur thermoélectrique (3) :
- est installé directement sur le composant (1) dégageant de la chaleur en étant relié à celui-ci en thermoconduction,
- comporte un élément (6) dégageant de la chaleur et muni d'ailettes (7), et
- comporte un élément (6) dégageant de la chaleur qui est couvert par un élément formant écran (8) vis-à-vis du rayonnement thermique du composant (1) dégageant de la chaleur,
**caractérisé en ce que**
le composant (1) dégageant de la chaleur est un bloc moteur d'un véhicule automobile, et
il est prévu une installation électrique de chauffage ou de maintien de chaleur, alimentée en énergie électrique par le générateur thermoélectrique (3) et qui après coupure du moteur du véhicule (1) chauffe ou maintien en température un accumulateur d'énergie électrique du véhicule.

2. Véhicule selon la revendication 1,
**caractérisé en ce que**
le générateur thermoélectrique est installé directement sur le boitier (2) du moteur (1) du véhicule.

3. Véhicule selon la revendication 1 ou 2,
**caractérisé en ce que**
son moteur (1) est un moteur à combustion interne.

4. Véhicule selon l'une des revendications 1 à 3,
**caractérisé en ce que**
le générateur thermoélectrique est installé directement sur la cuve à huile du moteur du véhicule (1).

5. Véhicule selon l'une des revendications 1 à 4,
**caractérisé en ce que**
l'élément (6, 7) dégageant de la chaleur est installé pour être parcouru ou balayé par le vent de circulation.

6. Véhicule selon l'une des revendications 1 à 5,
**caractérisé par**
une machine soufflante qui souffle de l'air de refroidissement sur l'élément (6, 7) dégageant de la chaleur.

7. Véhicule selon l'une des revendications 1 à 6,
**caractérisé en ce que**
l'élément (6, 7) dégageant de la chaleur est relié au circuit de refroidissement du véhicule traversé par un liquide.

8. Véhicule selon l'une des revendications précédentes,
**caractérisé en ce que**
le générateur thermoélectrique (3) est relié électriquement à un accumulateur d'énergie électrique équipant le véhicule et l'énergie électrique générée par le générateur thermoélectrique (3) charge d'accumulateur d'énergie.

9. Véhicule selon l'une des revendications précédentes,
**caractérisé en ce que**
le générateur thermoélectrique (3) est relié directement au réseau électrique embarqué du véhicule et alimente en courant différents utilisateurs d'énergie électrique du véhicule.

10. Véhicule selon l'une des revendications précédentes,
**caractérisé par**
une installation de chauffage ou de maintien en température, électrique, alimentée en énergie électrique par le générateur thermoélectrique (3) et qui lorsque le moteur (1) du véhicule est coupé, chauffe électriquement ou maintien en température des liquides de fonctionnement tels que l'huile du moteur ou l'eau de refroidissement ou certains composants ou groupes de composants du moteur (1) du véhicule tels que le vilebrequin, les commandes de soupapes ou les pistons par chauffage électrique.
